# EUROPEAN PATENT SPECIFICATION

(11) **EP 1 201 899 B1**
(45) Date of publication and mention of the grant of the patent: **05.04.2006**
(21) Application number: 01101520.3
(22) Date of filing: 24.01.2001
(51) Int. Cl.: F02D 41/26, F02D 41/24

(54) **A control device for a vehicle motor**
Steuergerät für einen Kraftfahrzeugmotor
Appareil de commande d'un moteur de véhicule

(30) Priority: 16.10.2000 WO PCT/IT00/00412
(43) Date of publication of application: 02.05.2002
(73) Proprietor: STMicroelectronics S.r.l., 20041 Agrate Brianza (Milano) (IT); MAGNETI MARELLI POWERTRAIN S.p.A., 20011 Corbetta (Milano) (IT)
(72) Inventor: Pepi, Alessandro, 25128 Brescia (IT); Pezzini, Saverio, 20059 Vimercate (Milano) (IT); Marceca, Paolo, 40137 Bologna (IT); Ferrari, Alberto, 41031 Camposanto (Modena) (IT)
(74) Representative: Quinterno, Giuseppe

(56) References cited:
- WO-A-91/07754
- GB-A- 2 076 188
- US-A- 5 284 116
- US-A- 6 088 264

## Description

The present invention relates to a control device for a vehicle engine of the kind defined in the preamble of claim 1.

A control device of that kind is disclosed in GB-A-2 076 188.

Engines of modern vehicles (for example, motor cars) have various electronic systems which enable their operation to be controlled in the best possible manner. These systems are controlled by a device which sends corresponding control signals to the engine in accordance with configuration parameters stored in non-volatile memories of the control device, which in the device according to GB-A-2 076 188 are RAM memories.

During an operation to calibrate the control device, the configuration parameters are corrected to modify the operation of the engine; this calibration operation is typically performed in the factory at the vehicle-development stage, or in the workshop, to adapt the behaviour of the engine to various environmental conditions or conditions of wear of the components.

The calibration operation is generally performed in the field whilst the engine is in operation in order to check directly the results of the modifications applied. For this purpose, the control device is connected to an external computer which controls the modification of the configuration parameters read from the memory of the control device.

Another known solution, for use when the control device includes flash E²PROM memories, consists of the use of a specially constructed (custom) interface card which is connected to the control device by means of a high-speed parallel bus; the external computer is then connected to the interface card by means of a standard connector. During the calibration operation, at least some of the memory space of the control device (associated with the configuration parameters) is re-mapped in a working memory (RAM) of the interface card. The configuration parameters can thus be modified directly by the external computer (by means of a standard connection) whilst, at the same time, being used by the control device. Upon completion of the calibration operation, the new configuration parameters are then downloaded from the RAM memory of the interface card into the flash memory of the control device.

However, this solution is extremely expensive because of the low production volumes of the configuration cards and of the need to increase the number of external connection terminals of the control device (to permit real-time access to the configuration parameters downloaded to the RAM of the interface card). In particular, in applications with high operating frequencies, the external connection between the control device and the RAM of the interface card slows down access to the configuration parameters so that the control device cannot be calibrated in the field with performance identical to its actual performance.

The object of the present invention is to provide an improved control device of the initially defined kind. To achieve this object, a control device for a vehicle engine as indicated in the first claim is proposed.

Moreover, the invention also proposes a vehicle comprising the control device as claimed.

Further characteristics and the advantages of the solution according to the present invention will become clear from the following description of a preferred embodiment thereof, provided by way of non-limiting example with reference to the appended drawings, in which:
Figure 1 is a basic block diagram of a vehicle provided with the control device of the invention,
Figure 2 shows a detail of a cross-bar inside the control device.

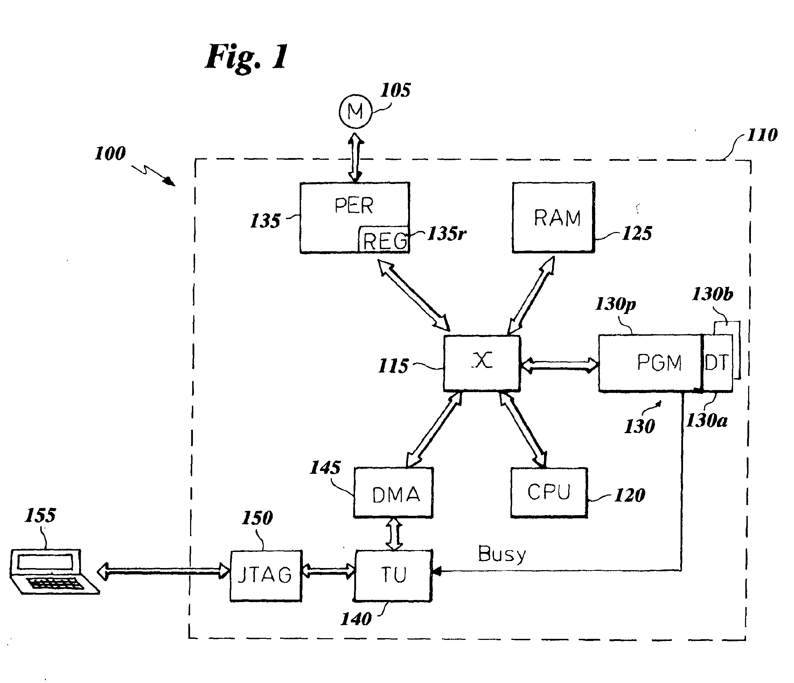

With reference in particular to Figure 1, a motor vehicle 100 has an engine 105; the operation of the engine 105 is managed by a control device 110 (which controls, for example, electronic injection, engine timing, and the like).

The control device 110 is formed by various units which are connected selectively in pairs by means of an interconnection unit (cross-bar) 115. In detail, a central processing unit (CPU) 120 manages the operation of the control device 110, a working memory (RAM) 125 is used directly by the CPU 120, and a non-volatile memory 130 contains programs and data for the operation of the CPU 120.

The memory 130, which is produced in integrated form on a single chip of semiconductor material, is constituted by a flash E²PROM memory (erasable and reprogrammable in blocks); the flash memory 130 is a read-while-write memory so that it is possible to erase and reprogram one block whilst data is read from another block.

The flash memory 130 stores a control program for the CPU 120 and configuration parameters of the engine 105, typically organized in vectors and matrices of coherent data, that is, of data relating as a whole to the control of a particular function of the motor 105. In particular, the program (PGM) is stored in a dedicated portion 130p of the flash memory. The flash memory includes two further portions 130a and 130b; each portion 130a, 130b is used alternatively in an active state for storing a current version of the configuration parameters (read by the program executed by the CPU 120) or in an inactive state for the writing (as described in detail below) of a new version of the configuration parameters.

A series of peripheral units 135 is also connected to the cross-bar 115; the peripheral units 135 consist, for example, of actuators for the regulation of the engine 105, or of sensors for measuring operating parameters thereof. Some of the peripheral units 135 (such as the actuators) have internal registers 135r which enable their operation to be regulated.

The control device 100 also includes a calibration unit (TU) 140 with which a DMA (direct memory access) controller 145, directly connected to the cross-bar 115, is associated. A dedicated line is used to send, from the flash memory 130 to the calibration unit 140, a signal (busy) indicative of a writing operation in progress in the flash memory 130. The calibration unit 140 also communicates with an interface 150, for example, of the JTAG (Joint Test Access Group) type commonly used for testing the control device 110 and for periodic checking of its functionality. An external computer, for example, a portable (laptop) computer 155, is connected to the control device 110 by means of a cable terminating in a PCMCIA connector inserted in a corresponding port associated with the JTAG interface 150.

The JTAG interface 150 consists of a control logic unit which manages the serial transfer of data with one or more shift registers. In particular, the JTAG interface provides a line JTDI for receiving an input binary datum (bit), a line JTDO for sending an output bit, a line JTTMS for selecting a test mode, an initialization (reset) line JTRST, and a line JTCLK for sending a dedicated clock signal. When the interface JTAG 150 is activated by the selection signal JTTMS, upon each leading edge of the clock signal JTCLK, the bit input on the line JTDI is recognized (strobed) and, upon each trailing edge of the clock signal JTCLK, a bit is output on the line JTDO. It is thus possible, with a series (a burst) of pulses of the clock signal JTCLK, to send to the control device 110 a series (a string) of bits which are loaded, in serial manner, into the shift register of the interface JTAG 150. Communication between the external computer 155 and the control device 100 is managed in a logical manner by a protocol, for example, of the Nexus type (defined by IEEE Standard 1149.1).

Both the CPU 120 and the DMA controller 145 operate in master mode for controlling access to the interconnection resources of the cross-bar 115 (within which there is an arbitrator which manages mutually exclusive access to the resources). These units (the CPU 120 and the DMA controller 145) have access to a memory space which is mapped in all of the resources of the control device 110 (the flash memory, the RAM memory, and the internal registers of the various units); in particular, the portion of the memory space which is dedicated to the current version of the configuration parameters (the current data space) is normally used by the CPU 120, whereas the portion of the memory space which is dedicated to the new version of the configuration parameters (data space being modified) is normally used by the DMA controller 145.

During a normal operation of the control device 110 (during which the external computer 155 is not connected), the control program of the CPU 120 accesses the current version of the configuration parameters stored in one of the data portions 130a, 130b which is in the active state (for example, the data portion 130a). The CPU therefore controls the peripheral units 135 so as to send corresponding control signals to the engine 105.

At the same time, the CPU can interrogate (poll) the peripheral units 135 periodically, for example, every hour, to measure operating parameters of the engine 105. The operating parameters read are written in the other data portion of the flash memory which is in the inactive state (the portion 130b in the example in question).

As soon as the external computer 155 is connected to the JTAG interface 150, a corresponding interrupt signal, for example, is sent to the CPU 120. The CPU consequently interrupts the storage of the operating parameters of the engine in the data portion 130b which is in the inactive state (whilst the reading of the configuration parameters from the portion 130a which is in the active state proceeds normally). The external computer 155 can thus load a command to read the operating parameters of the engine into the shift register of the JTAG interface 150. This read command is then supplied to the calibration unit 140 which manages the reading of the data portion 130b which is in the inactive state, directly by means of the DMA controller 145. The configuration parameters of the engine thus read are then supplied to the external computer 155 by the JTAG interface 150.

During an operation to calibrate the control device 110, the current version of the configuration parameter is downloaded to the external computer 155 in similar manner from the data portion 130a which is in the active state. The configuration parameters are modified in the external computer 155. The external computer 155 then loads a command to write a new configuration parameter in the shift register of the interface JTAG 150. The write command is then supplied to the calibration unit 140 which manages the writing of the data portion 130b which is in the inactive state, directly by means of the DMA controller 145. In the course of the operation to write the new configuration parameter, the flash memory 130 activates the busy signal; the calibration unit 140 does not therefore accept any subsequent command to write the flash memory until the writing operation in progress is completed (busy signal cancelled).

Once the updating of the new configuration parameters in the data portion 130b which is in the inactive state is completed, the external computer 155 sends a corresponding writing-completed signal to the calibration unit 140 (by means of the JTAG interface 150). As described in detail below, the states of the data portions 130a and 130b are consequently reversed; in the example in question, the data portion 130a switches to the inactive state and the data portion 130b switches to the active state. The management program of the CPU 120 thus automatically accesses the new version of the configuration parameters stored in the data portion 130b (whilst the other data portion 130a becomes available for further modification).

The external computer 155 can also load a command to read the registers 135r into the shift register of the JTAG interface 150. This read command is then supplied to the calibration unit 140 which manages the reading of the registers 135b directly, by means of the DMA controller 145. The values thus read are then supplied to the external computer 155 by means of the JTAG interface 150.

Similar considerations apply if the control device is used in a vehicle of a different type (for example, a motor cycle) or has a different structure (for example, with the various units connected in parallel to a bus), if the external computer is of a different type, for example, of the palmtop type, if it is connected to the control device by means of a connector of another type (for example, of the RJ45 type), or if the communication between the external computer and the control device uses a different protocol, and the like.

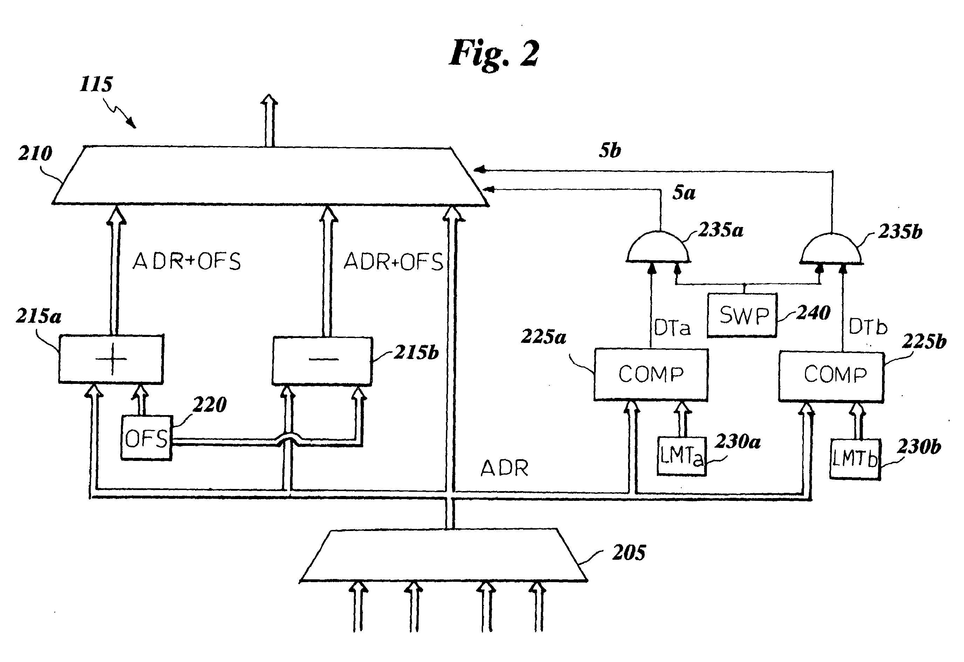

With reference now to Figure 2, this shows a detail of the cross-bar 115 associated with a port for connection to the flash memory. The cross-bar 115 includes a multiplexer 205 having four inputs each of which is connected to one of the other connection ports of the cross-bar 115 (associated with the CPU, the RAM memory, the peripheral units and the DMA controller); the multiplexer 205 receives an address transmitted by the CPU or by the DMA controller to the respective connection port.

The multiplexer 205 transmits this address (ADR) as an output in dependence on a selection signal (generated by the arbitrator of the cross-bar 115). A further multiplexer 210 has three inputs connected, respectively, to an output of the multiplexer 205, to an output of an adder 215a, and to an output of a subtractor 215b; the signal output by the multiplexer 210 is transferred to the port for connection to the flash memory. The adder 215a and the subtractor 215b receive, at respective inputs, the address ADR and an offset value OFS stored in a register 220; the offset OFS is equal to the difference between a first address of the data space being modified and a first address of the current data space.

The address ADR is also supplied to a first input of a comparator 225a; a second input of the comparator 225a receives a signal (LMTa) stored in a register 230a. Similarly, the address ADR is supplied to a first input of a further comparator 225b; a second input of the comparator 225b receives a signal (LMTb) stored in a further register 230b. The signal LMTa and the signal LMTb define the limits of the current data space and the limits of the data space being modified, respectively.

The comparator 225a outputs a bit DTa indicative of the fact that the address ADR falls within the limits of the current data space; the comparator 225b outputs a bit DTb indicative of the fact that the address ADR falls within the limits of the data space being modified. The bit DTa and the bit DTb are supplied, respectively, to a first input of an AND logic gate 235a and to a first input of an AND logic gate 235b; the AND gates 235a and 235b receive, at respective second inputs,a flag SWP for inverting the memory mapping of the current data space and of the data space being modified. The AND gate 235a outputs a bit Sa and the AND gate outputs a bit Sb, and these are applied to respective selection inputs of the multiplexer 210.

Each time an address ADR has to be transmitted from a unit of the control device (the CPU, the RAM memory, the peripheral units, or the DMA controller) to the flash memory, this value is compared by the comparators 225a and 225b with the limits of the current data space and with the limits of the data space being modified, respectively. If the address ADR does not fall within any of these limits (for example, because it relates to an instruction of the control program of the CPU), both of the bits DTa and DTb are cancelled (logic level 0) so that both of the bits Sa and Sb are also cancelled (irrespective of the value of the flag SWP). The combination Sa,Sb=00 transfers the address ADR as an output to the multiplexer 210 so as to access the flash memory normally.

If, however, the address ADR falls, for example, within the limits of the current data space, the corresponding bit Dta is set at logic level 1 (whilst the bit Dtb is cancelled). Upon the assumption that the flag SWP is cancelled, the bits Sa,Sb also adopt the value 00 in this case so that the address ADR is transferred as an output to the multiplexer 210 so as to access a corresponding location of a predetermined one of the data portions of the flash memory (for example, the first portion indicated 130a in Figure 1).

If, however, the flag SWP is activated, the bit Sa adopts the value 1. The combination Sa,Sb=10 transfers the value ADR+OFS generated by the adder 215a as an output to the multiplexer 210; a corresponding location of the other data portion of the flash memory (the portion indicated 130b in Figure 1 in the case in question) is thus accessed. Complementary considerations apply if the address ADR falls within the limits of the data space being modified (with the combination Sa,Sb=01 which transfers the value ADR-OFS generated by the subtractor 215b as an output to the multiplexer 210 when the address ADR falls within the limits of the space being modified and SWP=1).

The registers 220, 230a, 230b and 240 are set in response to an initialization (reset) command. Each time the calibration unit receives a writing-completed signal from the external computer, it sends an interrupt signal to the CPU 120. The CPU consequently performs a service routine which inverts the value of the flag SWP stored in the register 240 (so as to switch the states of the flash-memory data portions). The interrupt signal is preferably masked by the management program of the CPU during an operation to read a coherent data structure so as to be used only when all of the configuration parameters of the structure have been read.

Similar considerations apply if the cross-bar has a different structure, if the functions described above are performed by other circuit components (possibly outside the cross-bar), and the like.

More generally, in the solution according to the present invention, the control device includes a first portion and a second portion of the memory unit each of which can be used alternatively in an active state for storing a current version of the configuration parameters or in an inactive state for the writing of a new version of the configuration parameters, the processing unit accessing the portion which is in the active state, for reading, and the input/output unit accessing the portion which is in the inactive state, for writing, and means for selectively switching one of the portions to the active state and the other of the portions to the inactive state.

This solution is particularly economical since it does not require the provision of any specially constructed components for the calibration operation. Moreover, the configuration data is accessed by the CPU directly in the flash memory, even during the calibration operation; the performance of the control device is consequently substantially identical to its actual performance, even during calibration operations in the field. This result is achieved with a negligible increase in the size of the flash memory (since the configuration parameters are only a very small part of the information stored therein).

The preferred embodiment of the present invention described above offers further advantages. In particular, the use of two banks of a single read-while-write flash memory (for storing the current version and the new version of the configuration parameters) achieves a particularly compact structure (with a single memory and respective control circuits).

The use of a current data space and of a data space being modified, which are mapped alternatively in different portions of the flash memory renders the switching mechanism completely transparent to the CPU.

The management of the switching of the states of the portions of the flash memory by interruption is particularly quick and easy. The masking of the interrupt signal during the reading of a coherent data structure also ensures that the operating parameters used by the control device are modified only at safe moments, so as to ensure correct operation of the engine.

The busy signal sent by the flash memory to the calibration unit enables the operation of the external computer (fast) to be synchronized with that of the flash memory (slow) without slowing down the operation of the control device in any way.

Similar considerations apply if a different mechanism is used for mapping the current version and the new version of the configuration parameters in the two data portions (for example, by simultaneously sending each address to the two data portions and enabling one of the data portions alternatively by means of the flag SWP). The solution of the present invention may, however, also be implemented with two separate flash memories, with hardware switching of the states of the data portions (by means of two signals) without any control of the moment of switching, the external computer and the flash memory being synchronized by means of a flag (within the flash memory) which is indicative of the completion of the writing operation and is interrogated periodically by the calibration unit, and the like.

The writing of the operating parameters of the engine in the data portion which is in the inactive state enables this portion of the flash memory (which is normally not used during the normal operation of the control device) to be utilized for diagnostic functions or for the collection of information during endurance tests.

The fact that the internal registers of the various peripheral units can be modified directly by the external computer renders the structure particularly flexible; for example, this enables the operation of the actuators to be regulated very easily.

The use of the JTAG interface enables functions already present in the control device to be utilized and does not require the addition of any new external connection terminals; moreover, this enables the external computer to be connected to the control device by standard connectors. The calibration unit with the respective DMA controller renders the writing of the new configuration parameters completely transparent to the external computer; this result is achieved independently of the CPU, with negligible slowing of the operation of the control device (due solely to any conflict with the CPU for access to the cross-bar).

Similar considerations apply if a different serial test interface is used. Alternatively*,* the calibration unit is not of the master type and the writing of the new configuration parameters in the flash memory is controlled directly by the CPU, the control device provides for a different input/output unit for connection to the external computer (with a dedicated interface and respective additional connection terminals), and the like.

Naturally, in order to satisfy contingent and specific requirements, a person skilled in the art may apply to the above-described solution many modifications and variations all of which, however, are included within the scope of protection of the invention as defined by the appended claims.

## Claims

1. A control device (110) for a vehicle engine (105) comprising a memory unit (130) for storing engine configuration parameters, a processing unit (120) for sending control signals to the engine in accordance with the configuration parameters, and an input/output unit (140-150) connectible to an external computer (155) in order to modify the configuration parameters, the control device (110) including a first portion (130a) and a second portion (130b) of the memory unit, each portion being usable alternatively in an active state for storing a current version of the configuration parameters or in an inactive state for the writing of a new version of the configuration parameters, the processing unit accessing the portion which is in the active state, for reading, and the input/output unit accessing the portion which is in the inactive state, for writing, and means (210-240) for selectively switching one of the portions to the active state and the other of the portions to the inactive state;
**characterized in that**
the first portion and the second portion consist, respectively, of a first bank (130a) and of a second bank (130b) of a single read-while-write flash E²PROM memory (130), and **in that** said memory unit (130) is predisposed to supply a signal of completion of a writing operation to the input/output unit (140-150) on a dedicated line and the input/output unit (140-150) is predisposed to accept a writing command from the external computer (155) only if the completion signal is activated.

2. A control device (110) according to Claim 1 in which the current version of the configuration parameters is accessed by the processing unit (120) by means of corresponding addresses of a first space and the new version of the configuration parameters is accessed by the input/output unit (140-150) by means of corresponding address of a second space, the switching means (210-240) comprising an indicator (240) of the state of the first portion (130a) and of the second portion (130b) and means (210-235) for associating with each address of the first space and of the second space a corresponding location of the first portion or of the second portion, in accordance with the state indicator.

3. A. control device (110) according to Claim 1 or Claim 2 in which the input/output unit (140-150) sends an interrupt signal to the processing unit (120) in response to a signal of the completion of the writing of the new version of the configuration parameters by the external computer (155), and the processing unit switches the state indicator (240) in response to the interrupt signal.

4. A control device (110) according to Claim 3 in which the configuration parameters are organized in coherent data structures which cannot be modified during a reading operation, the interrupt signal being masked during an operation to read a coherent data structure.

5. A control device (110) according to any one of Claims 1 to 4, further comprising means (140) for writing operating parameters of the engine in the portion which is in the inactive state, the input/output unit (140-150) reading the operating parameters from the portion which is in the inactive state and supplying the operating parameters read to the external, computer (155) in response to a corresponding request signal from the external computer.

6. A control device (110) according to any one of Claims 1 to 5, further comprising at least one peripheral unit (140) for interfacing with the engine (105), having a plurality of internal registers (140r), the input/output unit (140-155) modifying the registers in response to a corresponding request signal from the external computer (155).

7. A control device (110) according to any one of Claims 1 to 6 in which the input/output unit (140-150) includes a serial test interface (150) for exchanging information with the external computer (155) and a further processing unit (140, 145) for accessing internal resources of the control device (110), independently of the processing unit (120).

8. A vehicle (100) comprising an engine (105) and the engine control device (110) according to any one of Claims 1 to 7.

## Patentansprüche

1. Steuergerät (110) für einen Fahrzeugmotor (105), umfassend eine Speichereinheit (130) für das Speichern von Motorkonfigurationsparametern, eine Verarbeitungseinheit (120) zum Senden von Steuersignalen an den Motor entsprechend den Konfigurationsparametern und eine Eingabe/Ausgabeeinheit (140-150), die an einem externen Rechner (155) anschließbar ist, um die Konfigurationsparameter zu modifizieren, wobei das Steuergerät (110) einen ersten Abschnitt (130a) und einen zweiten Abschnitt (130b) der Speichereinheit umfasst, wobei jeder Abschnitt wahlweise in einem aktiven Zustand zum Speichern einer aktuellen Version der Konfigurationsparameter oder in einem inaktiven Zustand zum Schreiben einer neuen Version der Konfigurationsparameter verwendbar ist, wobei die Verarbeitungseinheit zum Ablesen auf den sich im aktiven Zustand befindlichen Abschnitt zugreift und die Eingabe/Ausgabeeinheit zum Schreiben auf den sich im inaktiven Zustand befindlichen Abschnitt zugreift, sowie Mittel (210-240) zum gezielten Umschalten des einen Abschnitts in den aktiven Zustand und des anderen Abschnitts in den inaktiven Zustand;
**dadurch gekennzeichnet, dass** der erste Abschnitt und der zweite Abschnitt aus einer ersten Bank (130a) bzw. einer zweiten Bank (130b) eines einzigen Read-While-Write-Flash-E²PROM-Speichers (130) bestehen und dass die Speichereinheit (130) dazu eingerichtet ist, auf einer Standleitung ein Signal der Beendigung einer Schreiboperation an die Eingabe/Ausgabeeinheit (140-150) zu liefern, und die Eingabe/Ausgabeeinheit (140-150) dazu. eingerichtet ist, nur bei Aktivierung des Beendigungssignals vom externen Rechner (155) einen Schreibbefehl zu empfangen.

2. Steuergerät (110) gemäß Anspruch 1, wobei von der Verarbeitungseinheit (120) mittels entsprechender Adressen eines ersten Raums auf die aktuelle Version der Konfigurationsparameter zugegriffen wird und von der Eingabe/Ausgabeeinheit (140-150) mittels einer entsprechenden Adresse eines zweiten Raums auf die neue Version der Konfigurationsparameter zugegriffen wird, wobei die Schaltmittel (210-240) einen Indikator (240) für den Zustand des ersten Abschnitts (130a) und des zweiten Abschnitts (130b) umfassen, sowie Mittel (210-235), um jeder Adresse des ersten Raums und des zweiten Raums in Übereinstimmung mit dem Zustandsindikator eine entsprechende Position des ersten Abschnitts oder des zweiten Abschnitts zuzuordnen.

3. Steuergerät (110) gemäß Anspruch 1 oder Anspruch 2, wobei die Eingabe/Ausgabeeinheit (140-150) als Reaktion auf ein Signal der Beendigung des Schreibens der neuen Version der Konfigurationsparameter durch den externen Rechner (155) ein Unterbrechungssignal an die Verarbeitungseinheit (120) sendet und die Verarbeitungseinheit den Zustandsindikator (240) als Reaktion auf das Unterbrechungssignal umschaltet.

4. Steuergerät (110) gemäß Anspruch 3, wobei die Konfigurationsparameter in kohärenten Datenstrukturen organisiert sind, welche während einer Leseoperation nicht modifiziert werden können, wobei das Unterbrechungssignal während einer Operation zum Ablesen einer kohärenten Datenstruktur verdeckt ist.

5. Steuergerät (110) gemäß einem der Ansprüche 1 bis 4, weiters umfassend Mittel (140) zum Schreiben von Betriebsparametern des Motors in dem Abschnitt, der sich im inaktiven Zustand befindet, wobei die Eingabe/Ausgabeeinheit (140-150) die Betriebsparameter von dem Abschnitt, der sich im inaktiven Zustand befindet, abliest und die abgelesenen Betriebsparameter als Reaktion auf ein entsprechendes Anforderungssignal des externen Rechners zum externen Rechner (155) liefert.

6. Steuergerät (110) gemäß einem der Ansprüche 1 bis 5, weiters umfassend zumindest eine periphere Einheit (140) zum Koppeln mit dem Motor (105), welche Einheit eine Mehrzahl von internen Registern (140r) aufweist, wobei die Eingabe/Ausgabeeinheit (140-155) als Reaktion auf ein entsprechendes Anforderungssignal des externen Rechners (155) die Register modifiziert.

7. Steuergerät (110) gemäß einem der Ansprüche 1 bis 6, wobei die Eingabe/Ausgabeeinheit (140-150) eine Serientest-Schnittstelle (150) zum Austauschen von Informationen mit dem externen Rechner (155) und eine weitere Verarbeitungseinheit (140, 145) zum Zugreifen auf interne Ressourcen des Steuergeräts (110) unabhängig von der Verarbeitungseinheit (120) umfasst.

8. Fahrzeug (100), umfassend einen Motor (105) und das Motorsteuergerät (110) gemäß einem der Ansprüche 1 bis 7.

## Revendications

1. Dispositif de commande (110) d'un moteur de véhicule (105) comprenant une unité de mémoire (130) destinée à stocker des paramètres de configuration du moteur, une unité de traitement (120) destinée à envoyer des signaux de commande au moteur selon les paramètres de configuration, et une unité d'entrée/sortie (140-150) pouvant être connectée à un ordinateur externe (155) afin de modifier les paramètres de configuration, le dispositif de commande (110) comprenant une première partie (130a) et une seconde partie (130b) de l'unité de mémoire, chaque partie étant utilisable alternativement dans un état actif pour stocker une version actuelle des paramètres de configuration ou dans un état inactif pour l'écriture d'une nouvelle version des paramètres de configuration, l'unité de traitement accédant à la partie qui est dans l'état actif, pour lire, et l'unité d'entrée/sortie accédant à la partie qui est dans l'état inactif, pour écrire, et des moyens (210-240) destinés à commuter sélectivement l'une des parties à l'état actif et l'autre des parties à l'état inactif ;
**caractérisé en ce que** la première partie et la seconde partie se composent, respectivement, d'une première banque (130a) et d'une seconde banque (130b) d'une mémoire flash E²PROM lecture-écriture (130), et **en ce que** ladite unité de mémoire (130) est prédisposée pour fournir un signal de fin d'une opération d'écriture à l'unité d'entrée/sortie (140-150) sur une ligne dédiée et l'unité d'entrée/sortie (140-150) est prédisposée pour accepter une commande d'écriture de l'ordinateur externe (155) uniquement si le signal de fin est activé.

2. Dispositif de commande (110) selon la revendication 1, dans lequel l'unité de traitement (120) accède à la version actuelle des paramètres de configuration par le biais des adresses correspondantes d'un premier espace et l'unité d'entrée/sortie (140-150) accède à la nouvelle version des paramètres de configuration par le biais de l'adresse correspondante d'un second espace, les moyens de commutation (210-240) comprenant un indicateur (240) de l'état de la première partie (130a) et de la seconde partie (130b) et des moyens (210-235) destinés à associer avec chaque adresse du premier espace et du second espace un emplacement correspondant de la première partie ou de la seconde partie, selon l'indicateur d'état.

3. Dispositif de commande (110) selon la revendication 1 ou la revendication 2, dans lequel l'unité d'entrée/sortie (140-150) envoie un signal d'interruption à l'unité de traitement (120) en réponse à un signal de la fin de l'écriture de la nouvelle version des paramètres de configuration par l'ordinateur externe (155), et l'unité de traitement commute l'indicateur d'état (240) en réponse au signal d'interruption.

4. Dispositif de commande (110) selon la revendication 3, dans lequel les paramètres de configuration sont organisés en structures de données cohérentes qui ne peuvent pas être modifiées pendant une opération de lecture, le signal d'interruption étant masqué pendant une opération de lecture d'une structure de données cohérentes.

5. Dispositif de commande (110) selon l'une quelconque des revendications 1 à 4, comprenant en outre des moyens (140) destinés à écrire des paramètres de fonctionnement du moteur dans la partie qui est dans l'état inactif, l'unité d'entrée/sortie (140-150) lisant les paramètres de fonctionnement depuis la partie qui est dans l'état inactif et fournissant les paramètres de fonctionnement lus à l'ordinateur externe (155) en réponse à un signal de requête correspondant de l'ordinateur externe.

6. Dispositif de commande (110) selon l'une quelconque des revendications 1 à 5, comprenant en outre au moins une unité périphérique (140) destinée à servir d'interface avec le moteur (105), ayant une pluralité de registres internes (140r), l'unité d'entrée/sortie (140-155) modifiant les registres en réponse à un signal de requête correspondant de l'ordinateur externe (155).

7. Dispositif de commande (110) selon l'une quelconque des revendications 1 à 6, dans lequel l'unité d'entrée/sortie (140-150) comprend une interface de test série (150) destinée à échanger des informations avec l'ordinateur externe (155) et une autre unité de traitement (140,145) destinée à accéder aux ressources du dispositif de commande (110), indépendamment de l'unité de traitement (120).

8. Véhicule (100) comprenant un moteur (105) et le dispositif de commande de moteur (110) selon l'une quelconque des revendications 1 à 7.
